# EUROPEAN PATENT SPECIFICATION

(11) **EP 1 434 256 B1**
(45) Date of publication and mention of the grant of the patent: **14.09.2011**
(21) Application number: 03029812.9
(22) Date of filing: 23.12.2003
(51) Int. Cl.: H01L 21/00

(54) **Thin plate supporting container**
Behälter für dünne Scheiben
Conteneur de plaquettes fines

(30) Priority: 27.12.2002 JP 2002379340
(43) Date of publication of application: 30.06.2004
(60) Divisional application: 10009630.4
(73) Proprietor: Miraial Co., Ltd., Tokyo (JP)
(72) Inventor: Matsutori, Chiaki, Oaza-Yoshitomi. Shisui. Kikuchi. Kumamoto (JP); Obayashi, Tadahiro, Oaza-Yoshitomi, Shisui, Kikuchi, Kumamoto (JP)
(74) Representative: Grünecker, Kinkeldey, Stockmair & Schwanhäusser Anwaltssozietät

(56) References cited:
- EP-A- 1 004 524
- EP-A1- 1 152 455
- EP-A2- 0 768 706
- EP-A2- 1 043 758
- EP-A2- 1 047 112
- WO-A2-02/47118
- WO-A2-98/59229
- DE-A1- 19 830 640
- DE-A1- 19 848 147
- DE-A1- 19 924 182
- GB-A- 2 324 413
- GB-A- 2 338 924
- JP-A- 9 045 759
- JP-A- 10 189 704
- JP-A- 11 074 337
- JP-A- 11 189 288
- JP-A- 2000 043 976
- JP-A- 2000 323 560
- JP-A- 2002 353 299
- US-A- 5 555 981
- US-A- 5 992 638
- US-A- 6 039 186

## Description

### BACKGROUND OF THE INVENTION

### Field of the Invention

The present invention relates to a thin plate supporting container for housing, storing, and transporting thin plates such as semiconductor wafers, storage disks, or liquid crystal glass substrates.

### Related Background Art

A thin plate supporting container is generally constructed by a container body and a lid unit for closing the upper opening of the container body. In the container body, slotted plates are provided on opposite side walls, and a plurality of thin plates such as semiconductor wafers are supported between the slotted plates.

The slotted plates are detachably supported in the container body. Specifically, a supporting hole is opened on the slotted plate side and a supporting projection is provided on the container body side. By the supporting hole and the supporting projection, the slotted plates are detachably supported in the container body.

For example, International Publication WO99/39994 discloses the technique. A supporting hole is opened on a slotted plate (thin plate supporting member) side and a supporting projection to be fit in the supporting hole is provided on the container body side. The sets each consisting of the supporting hole and the supporting projection are provided in three positions.

Since the sets of the supporting hole and the supporting projection are provided in three positions, the slotted plate is not deflected. A mode of providing the sets only in two positions at both ends of the slotted plate is also possible. In this case, however, since the supporting hole and the supporting projection have a circular shape and can rotate in a state where they fit with each other, the slotted plates may be deflected.

Further, since the slotted plate is positioned by the supporting hole and the supporting projection, the position in the deep portion of the slotted plate may be slightly deviated. In this case, in a state where the thin plate supporting container is disposed longitudinally, semiconductor wafers are supported in the deep portions of the slotted plates. If there is a positional deviation in the deep portions of the slotted plates, the position of supporting a semiconductor wafer is deviated in the thin plate supporting container.

A plurality of plate pieces constructing the slotted plate are formed so as to curve along the periphery of a semiconductor wafer close to an inlet/outlet port of semiconductor wafers. In this case, an inlet/outlet port side of a plate piece largely extends toward the semiconductor wafer side, so that the possibility that a semiconductor wafer to be supplied/taken out comes into contact with the plate piece is high. To solve the problem, the inlet/outlet port side of the plate piece has to be widened to the container body side. In this case, however, the semiconductor wafer supporting positions are on the deep side and an intermediate position. There is no support near the inlet/outlet port, so that supporting is unstable.

Between a semiconductor wafer housed in the thin plate supporting container and the bottom plate of the thin plate supporting container, a sufficient gap is provided to prevent the semiconductor wafer from coming into contact with the bottom plate in case of an abnormal shock of a fall of the thin plate supporting container or the like. In this case, however, the thin plate supporting container is tall. When the thin plate supporting container is packed in a box, the gap between the bottom of the box and the bottom of the thin plate supporting container is small. Accordingly, an amount of cushioning which is put between the bottom of the box and the bottom of the thin plate container becomes small. Although there is no problem in a normal transportation state, in case of occurrence of an abnormal shock due to a fall from a high place or the like, the small amount of the cushioning becomes some trouble. It is preferable that the amount of cushioning is larger.

A top flange and a handle are detachably attached to the thin plate supporting container. When an external force which is strong in the direction of pulling out the top flange or handle is applied by an abnormal shock of a fall of the thin plate supporting container or the like, there is the possibility that a locking pawl or the like comes off and the top flange or the like drops.

There is also a case such that a known latch mechanism for fixing a lid unit to the container body is caught by the container body when the latch mechanism is unlatched to detach the lid unit.

On the back side of the lid unit, a thin plate pressing member is provided. Fitting grooves are formed in the thin plate pressing member. Semiconductor wafers are supported by being fit in the fitting grooves one by one. The fitting groove is formed in a V shape, the angle of the V-shaped fitting groove is usually an obtuse angle, and the periphery of a semiconductor wafer is lightly caught in the fitting groove. Although there is no problem in a normal use mode, by an abnormal shock of a fall of the thin plate supporting container or the like, semiconductor wafers may turn or be displaced. It cannot be said that the supporting force is sufficient.

The thin plate pressing member is constructed by a number of pressing bands disposed in parallel for supporting semiconductor wafers one by one at predetermined intervals, and the periphery of a semiconductor wafer is supported by being fit in a fitting groove formed in the pressing band. In this case, if a semiconductor wafer comes off from the fitting groove in the pressing band, the semiconductor wafer may be fit in the gap between the pressing bands.

On the bottom of the container body placed transversely, positioning means for positioning the thin plate supporting container is provided. The positioning means is constructed by three fitting grooves provided at almost equal intervals. When positioning projections on a base stand side fit in the fitting grooves, the container body is accurately positioned. Since the fitting grooves are made of the same material as that of the thin plate supporting container, in a state where the positioning projections are fit in the fitting grooves, the positioning projections do not slide smoothly. There is a case that the positioning projection stops midway in the fitting groove and accurate positioning cannot be performed.

### SUMMARY OF THE INVENTION

The present invention has been achieved in consideration of the above problems and its object is to provide a thin plate supporting container capable of accurately, reliably, and stably supporting a thin plate, to/from which a lid unit, a top end, and the like can be attached/detached reliably and easily, and which can be accurately positioned.

Another object is to prevent a disengagement of the top flange even if a strong impact is given to the top flange.

The object is achieved by the container according to claim 1.

With the structure, the supporting bar portion is formed so as to extend to the other-side member and to the front side of the sliding and supporting means. Therefore, in the case where a strong force is applied in the direction of making the top flange or the like come off, by the support of the supporting bar portion, disengagement of the top flange or the like is prevented. Thus, even if a strong impact is given to the top flange or the like, the top flange or the like does not come off.

According to a second aspect of the invention, in the thin plate supporting container according to the first aspect, the contact portion of the locking pawl is provided on the side of the other-side member than the base end portion of the supporting bar portion.

With the structure, since the contact portion of the locking pawl is provided on the side of the other-side member than the base end portion of the supporting bar portion, the contact portion is pressed strongly against the locking projection. Consequently, even if a strong force is applied by an impact or the like, the contact portion does not come off from the locking projection.

According to the invention, two supporting portions and two sliding portions of the sliding and supporting means are provided in parallel, and each of the interval between the supporting portions and the interval between the sliding portions is set to be small on the front side and to be large on the inner side.

With the structure, since the interval on the front side is set to be small and the interval on the inner side is set to be large, the sliding portion can be easily fit in the supporting portion.

According to a third aspect of the invention, the invention further includes guide rails for guiding two members supported by the sliding and supporting means so as to slide and performing positioning in a direction orthogonal to the sliding direction.

With the structure, by being guided by the guide rails, the two members supported by the sliding and supporting means can be easily attached/detached.

### BRIEF DESCRIPTION OF THE DRAWINGS

FIG. 1 is a sectional perspective view showing a thin plate supporting container according to an embodiment of the present invention.
FIG. 2 is a perspective view showing the thin plate supporting container according to the embodiment of the present invention.
FIG. 3 is a perspective view showing, from bottom side, the thin plate supporting container according to the embodiment of the present invention.

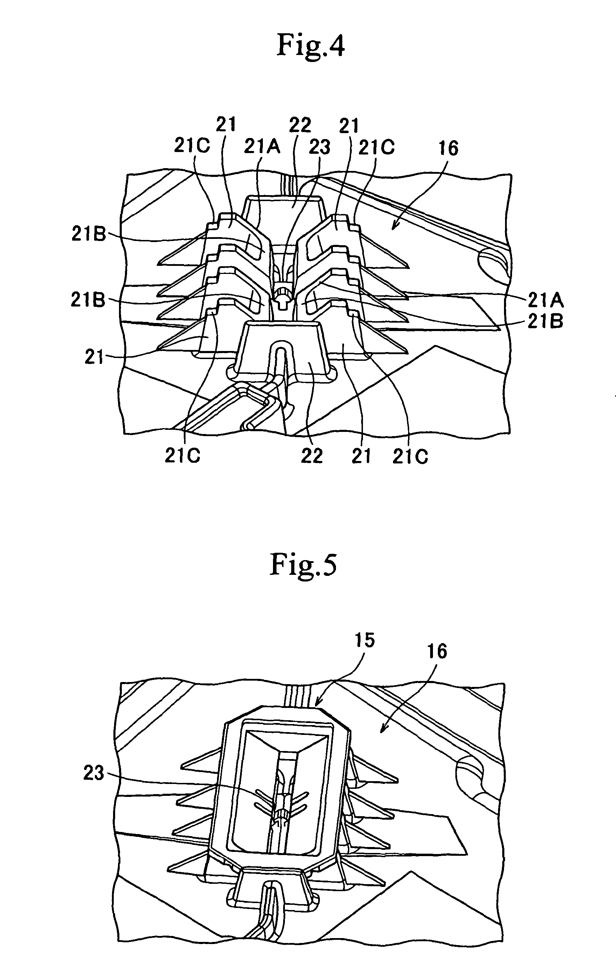

FIG. 4 is a perspective view showing a supporting stand of body positioning means.
FIG. 5 is a perspective view showing a state where a V-shaped groove plate piece is attached to the supporting stand of the body positioning means.
FIG. 6 is a perspective view showing the V-shaped groove plate piece of the body positioning means.
FIG. 7 is a perspective view showing, from the bottom side, the V-shaped groove plate piece of the body positioning means.
FIG. 8 is a sectional perspective view showing a state where the V-shaped groove plate piece is attached to the supporting stand of the body positioning means.
FIG. 9 is a perspective view showing a top flange according to the embodiment of the present invention.
FIG. 10 is a perspective view showing, from the bottom side, the top flange according to the embodiment of the present invention.
FIG. 11 is a partial perspective view showing the container body according to the embodiment of the present invention.
FIG. 12 is a perspective view showing the top flange side of an attaching/detaching mechanism according to the embodiment of the present invention.
FIG. 13 is a sectional perspective view showing a state where the top flange is attached to the container body.
FIG. 14 is a perspective view showing a state where the top flange is attached to the container body.
FIG. 15 is a perspective view of a main portion showing a state where the top flange is attached to the container body.
FIG. 16 is a cross sectional view of a main portion showing a state where a slotted plate is attached to the container body.
FIG. 17 is a perspective view showing the slotted plate.
FIG. 18 is a plan view showing the slotted plate.
FIG. 19 is an enlarged plan view showing the slotted plate.
FIG. 20 is a perspective view showing an upper fitting portion of the container body.
FIG. 21 is a perspective view showing a lower fitting portion of the container body.
FIG. 22 is an enlarged plan view showing the upper fitting portion of the container body.
FIG. 23 is an enlarged perspective view showing the lower fitting portion of the container body.
FIG. 24 is a perspective view showing a thin plate pressing member.
FIG. 25 is a plan view showing the thin plate pressing member.
FIG. 26 is a cross sectional view showing a fitting groove in the thin plate pressing member.
FIG. 27 is a perspective view showing a latch mechanism.
FIG. 28 is a perspective view showing a stopper of the latch mechanism.
FIG. 29 is a cross sectional view of a main portion showing a gasket.
FIG. 30 is a cross sectional view of a main portion showing a base end supporting portion of the gasket.

### DETAILED DESCRIPTION OF THE PREFERRED EMBODIMENTS

Embodiments of the invention will be described hereinbelow with reference to the appended drawings. A thin plate supporting container of the present invention is suitable as a container used in processes of housing, storing, transporting, and producing thin plates such as semiconductor wafers, storage disks, and liquid crystal glass substrates. In the embodiment, a thin film supporting container for housing semiconductor wafers will be described as an example.

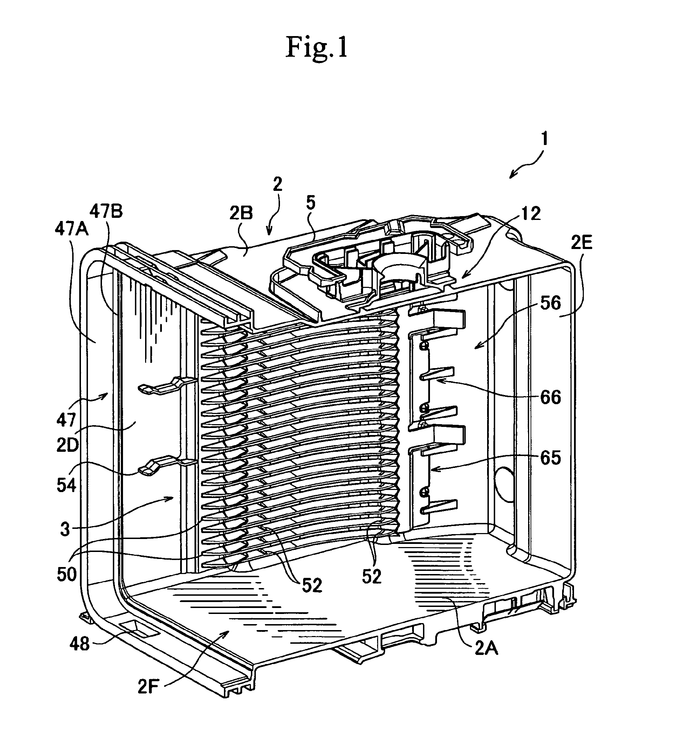

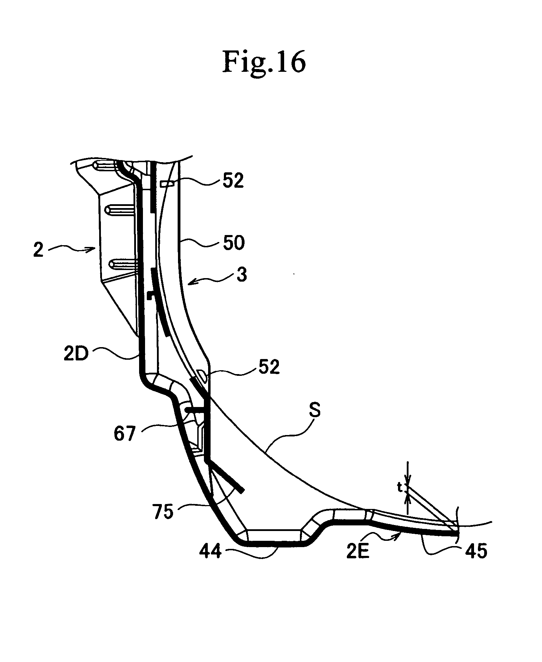

A thin plate supporting container 1 according to an embodiment has, as shown in FIGS. 1 to 3, a container body 2 for housing therein a plurality of semiconductor wafers S (refer to Fig. 16), two slotted plates 3 provided on opposite side walls in the container body 2 and supporting the housed semiconductor wafers S from both sides, a lid unit 4 for closing an opening 2F of the container body 2, a top flange 5 held by an arm of a transporting apparatus (not shown) , and a handle 6 for carry which is gripped by the user when the user carries the thin plate supporting container 1.

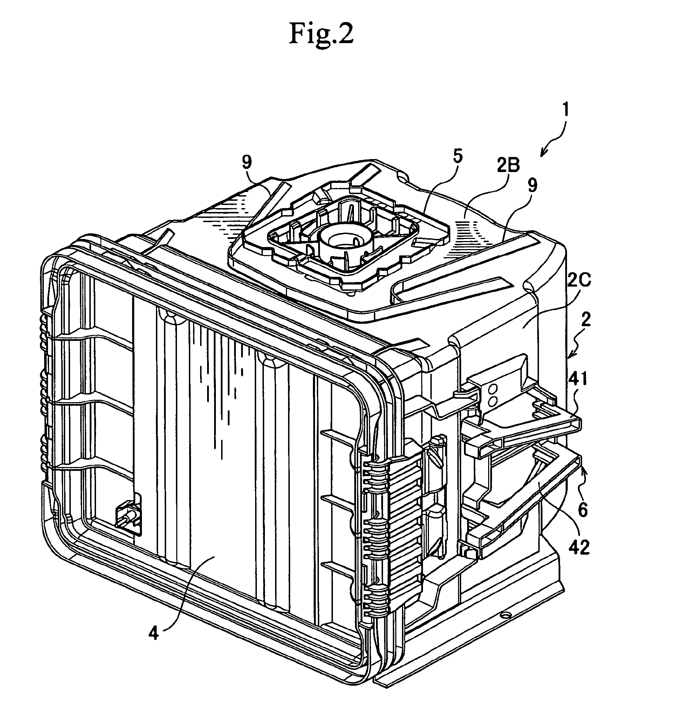

The container body 2 is formed in an almost cube shape. The container body 2 comprises four side walls 2A, 2B, 2C, and 2D serving as peripheral walls and a bottom plate 2E when the container body 2 is set longitudinally (in a state where the bottom plate 2E is down), and an opening 2F is provided at the top of the container body 2. Ribs 9 for reinforcement and the like are provided for each of the side walls 2A, 2B, 2C, and 2D. When the container body 2 is installed so as to face a robot (not shown) for carrying wafers in a manufacturing line of semiconductor wafers S or the like, it is positioned with accuracy and set on a stand transversely (the state of Fig. 2) . On the outside of the side wall 2A which serves as the bottom transversely, body positioning means 11 of the thin plate supporting container 1 is provided. The top flange 5 is detachably attached by an attaching/detaching mechanism 12 to the outside of the side wall 2B serving as the ceiling transversely. To the outside of the side walls 2C and 2D serving as side walls transversely, the handles 6 for carry are detachably attached.

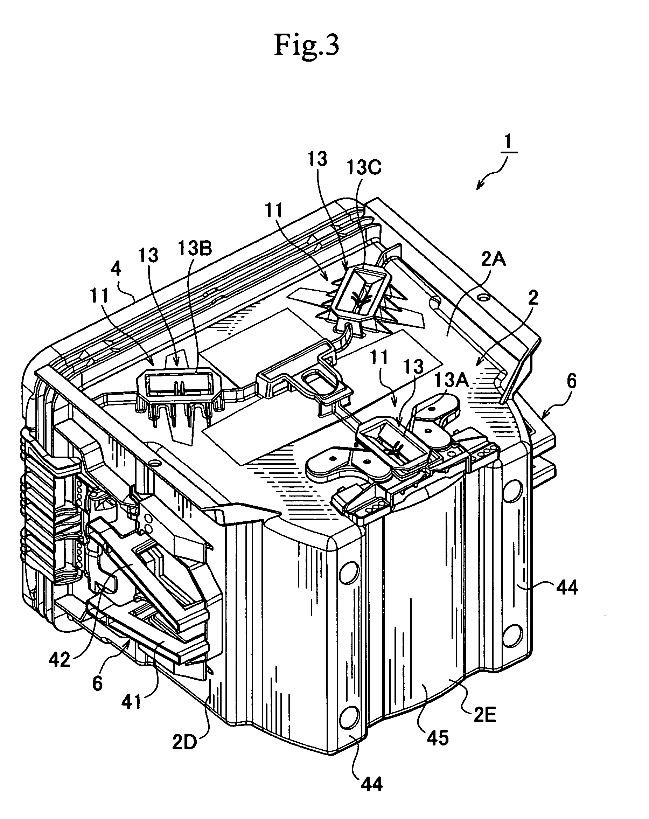

The body positioning means 11 is constructed by, as shown in Fig. 3, three V-shaped fitting grooves 13. The fitting grooves 13 are a first fitting groove 13A aligned in the vertical direction of the container body 2 and second and third fitting grooves 13B and 13C each inclined by an angle (almost 60 degrees) from the vertical direction of the container body 2. The three grooves 13 are set to have high dimensional precision in accordance with a standard. When the fitting grooves 13A, 13B, and 13C of the body positioning means 11 fit with fitting projections (not shown) of a stand used in a semiconductor fabricating process, the thin plate supporting container 1 is mounted in accurate position, and the semiconductor wafers S are taken in or inserted by a wafer carrying robot.

Each of the fitting grooves 13 is constructed by a V-shaped groove plate piece 15 and a supporting stand 16.

The V-shaped groove plate piece 15 is a member as a component of the fitting groove 13. The V-shaped groove plate piece 15 is constructed by a frame 17, inclined plates 18, and locking pawls 19.

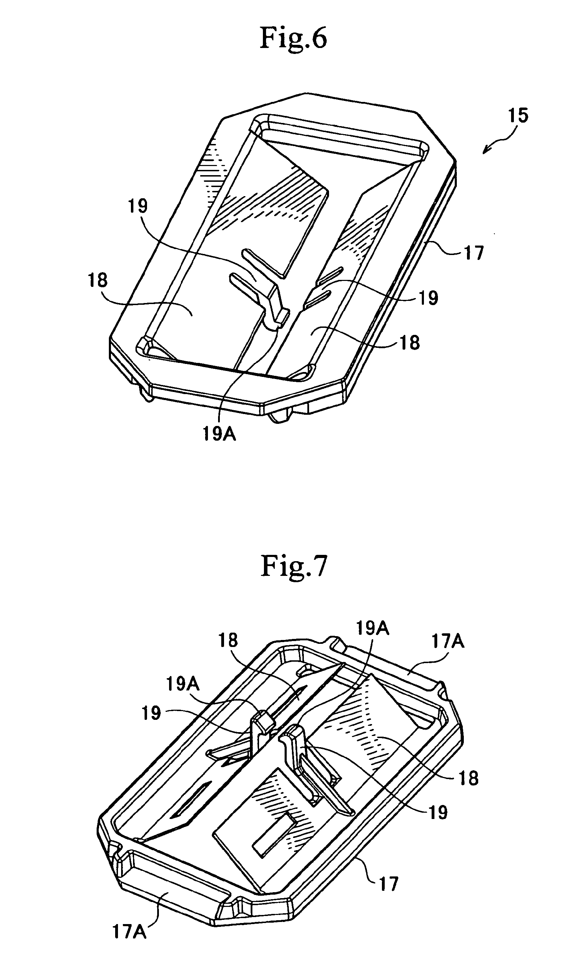

The frame 17 is a member for supporting the inclined plate 18 and the locking pawl 19. The frame 17 is formed in a rectangular shape so as to fit with a notch 21C for fitting of the supporting stand 16 which will be described later. In both end portions in the longitudinal direction of the frame 17, supporting plate fitting notches 17A which fit with end portion supporting plates 22 of the supporting stand 16 which will be described later to stably support the whole container are provided. The inclined plates 18 are members serving as inclined surfaces of the fitting groove 13. Two inclined plates 18 are provided for one frame 17. In a state where the base end portion of each of the inclined plates 18 is fixed to the frame 17, the inclined plates 18 extend downward to the inside. The thickness of the inclined plate 18 is set in relation with the supporting stand 16 so that the upper surface (the upper surface in Fig. 6) has a predetermined dimension. The V-shaped groove plate piece 15 is made of a material having low surface friction resistance, so that a fitting projection of a mounting stand used in the semiconductor fabricating process slides smoothly to perform accurate positioning of the thin plate supporting container 1. An example of the material is PBT.

The locking pawls 19 are members for fixing the V-shaped groove plate piece 15 to the supporting stand 16. The locking pawls 19 extend from the center portion of the inclined plate 18 downward to the inside. The tip of the locking pawl 19 is folded back to the perpendicular direction, and a nail portion 19A at the tip of the locking pawl 19 is locked by a locking projection 23 of the supporting stand 16 which will be described later. In such a manner, the V-shaped groove plate piece 15 is detachably attached to the supporting stand 16. Selectively, the V-shaped groove plate piece 15 of a material (material having low surface friction resistance) matched with the material of the fitting projection of the mounting stage used in the semiconductor fabricating process is attached. It makes the fitting projection on the other side easily slide in the V-shaped groove plate piece 15 to perform accurate positioning.

The supporting stand 16 is a member for supporting the V-shaped groove plate piece 15. The supporting stand 16 is constructed by an inclination supporting plate 21, an end-portion supporting plate 22, and a locking projection 23.

The inclination supporting plate 21 is a member for accurately positioning and supporting the inclined plate 18 of the V-shaped groove plate piece 15. Four plate pieces each having a U shape in plan view are arranged and inclined faces 21A formed along the V-shaped groove on the inner side of the four plate pieces come into direct contact with and support the inclined plates 18 of the V-shaped groove plate piece 15. The dimensions of the inclined face 21A are accurately set so that the upper surface of the inclined plate 18 of the V-shaped groove plate piece 15 supported by the inclined faces 21A come to have predetermined dimensions. Since mainly the tip portion of the fitting projection of the mounting stand used in the semiconductor fabricating process comes into contact with the inclined plate 18, an inner portion 21B of the inclined face 21A having a U shape in plan view is finished to have more accurate dimensions. In an upper end portion of the inclination supporting plate 21, the fitting notch 21C is provided. The fitting notch 21C is a notch with which the frame 17 of the V-shaped groove plate piece 15 fits. The V-shaped groove plate piece 15 is supported by eight fitting notches 21C.

The end-portion supporting plates 22 are members for supporting both ends in the longitudinal direction of the V-shaped groove thin plate piece 15 which fits with the fitting notches 21C of the inclination supporting plates 21. The end-portion supporting plate 22 is formed as an upright plate and is provided for each of the both ends of the inclination supporting plates 21. The upper end portion of the end-portion supporting plate 22 fits with the supporting plate fitting notch 17A of the frame 17 of the V-shaped groove plate 15, thereby stably supporting the V-shaped groove plate piece 15 while preventing a deviation in the longitudinal direction of the V-shaped groove plate piece 15.

The locking projection 23 is a member for supporting the V-shaped groove plate piece 15. The locking projection 23 is provided in the center portion between the inclined supporting plates 21. The upper end portion of the locking projection 23 is enlarged and locked by the nail portion 19A of the locking pawl 19 of the V-shaped groove plate piece 15.

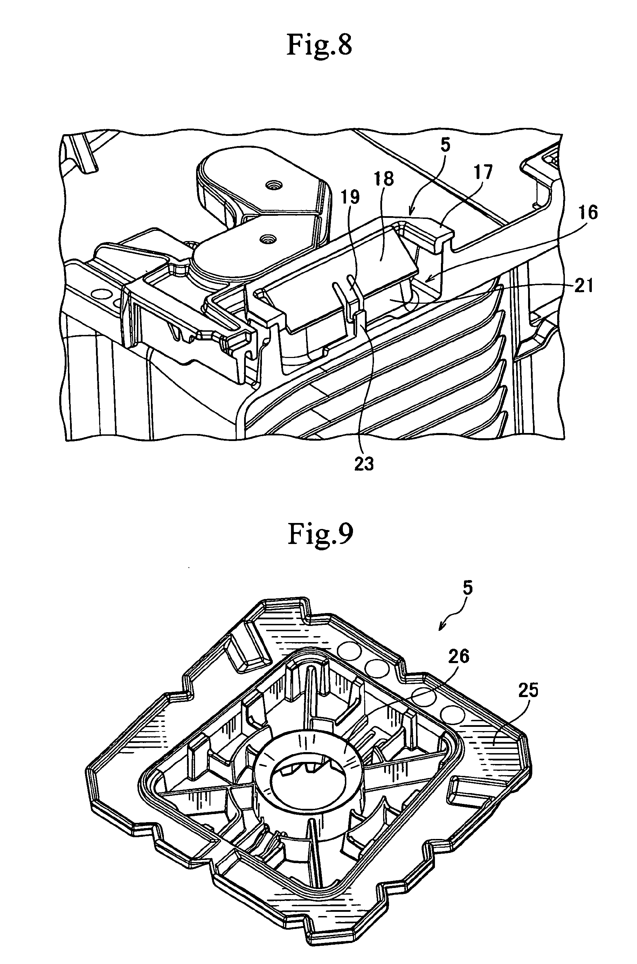

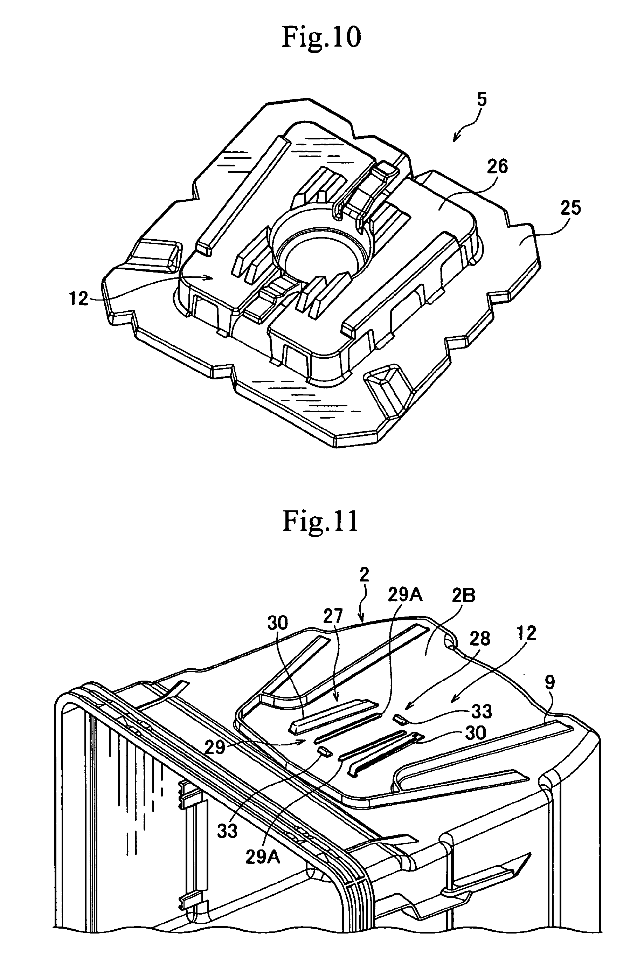

The top flange 5 is constructed by, as shown in Figs. 9 and 10, a flange portion 25 and a body portion 26. The flange portion 25 is a member to be gripped by an arm (not shown) of the transporting apparatus. In a factory or the like, the top flange 5 is gripped by the arm of the transporting apparatus and the thin plate supporting container 1 is transported. The body portion 26 is a member for supporting the flange portion 25 and attaching it to the container body 2. On the back face of the body portion 26, one of members of the attaching/detaching mechanism 12 which will be described later is provided.

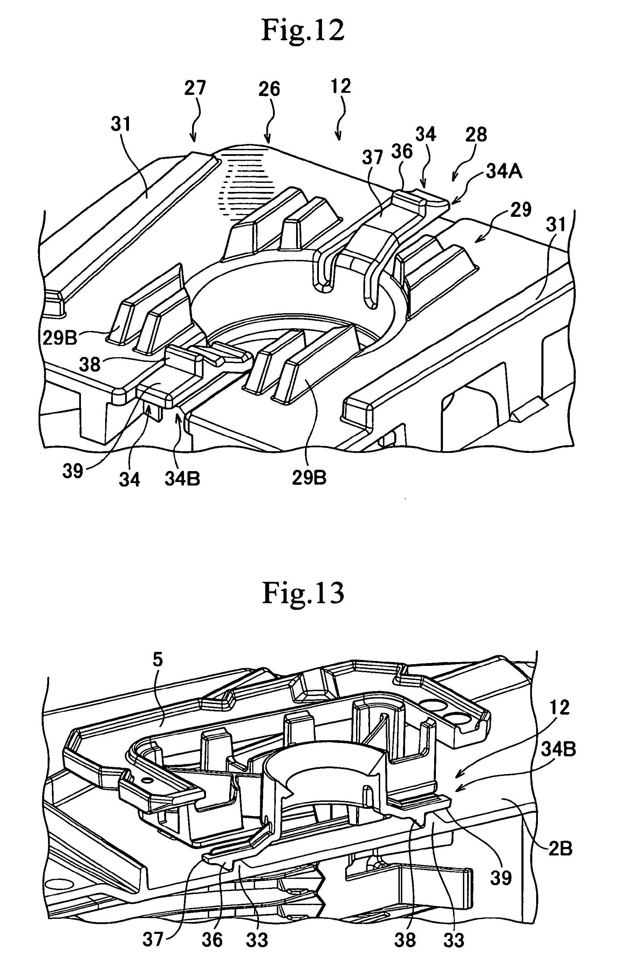

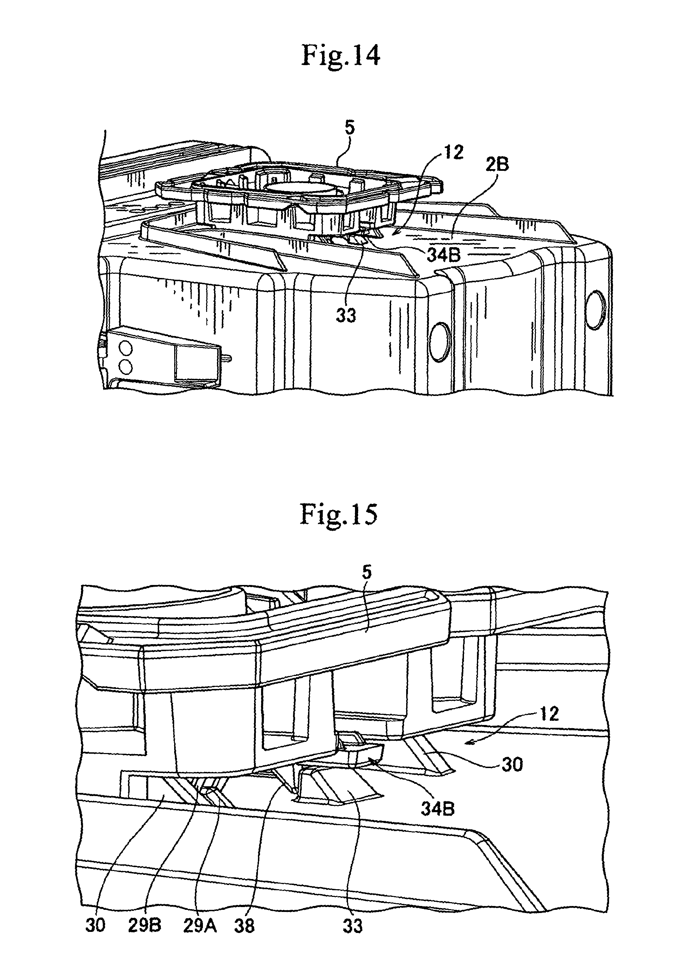

In the center portion of the side wall 2B of the container body 2, the other member of the attaching/detaching mechanism 12 for detachably attaching the top flange 5 is provided. The attaching/detaching mechanism 12 is constructed as shown by Fig. 1 and Figs. 11 to 15 Specifically, the attaching/detaching mechanism 12 is constructed by a sliding and supporting means 27, locking means 28, and guide rails 29.

The sliding and supporting means 27 is a member for slidably supporting the container body 2 and the top flange 5. The sliding and supporting means 27 is constructed by a supporting portion 30 provided on the container body 2 side and a sliding portion 31 provided on the top flange 5 side and inserted into the supporting portion 30 from the front side to the inner side (from the end on the right side to the end on the left side in Fig. 11). The supporting portion 30 is made by two rail members arranged in parallel on the outer surface of the side wall 2B of the container body 2. In the rail members, grooves which are open outward (the grooves provided on the outer sides of the two rail members and open to opposite sides) are formed. The sliding portion 31 is made by rail members provided in positions corresponding to the supporting portions 30 in the body portion 26 of the top flange 5. In the rail members, grooves which are open to the inside are provided. The supporting portion 30 and the sliding portion 31 are set so that the interval between the rail members on the front side (the right side in Fig. 11) is narrow and the interval on the deep side is wide. With the configuration, the sliding portion 31 can easily engage with the supporting portion 30.

The locking means 28 is a member for locking the container body 2 and the top flange 5 so as not to be deviated from each other, which are slidably supported by the sliding and supporting means 27. The locking means 28 is constructed by locking projections 33 provided on the container body 2 side and locking pawls 34 provided on the top flange 5 side. Two locking projections 33 are provided for the side wall 2B. Each of the locking projections 33 is provided in the center between both ends of the two rail members of the supporting portion 30. The surface of the locking projection 33 facing to the inner side (the left side in Fig. 11) serves as a perpendicular contact surface, and the locking projection 33 supports the locking pawl 34 so as not to be deviated to the front side (the right side in Fig. 11).

The locking pawl 34 is a member which is locked by the locking projection 33 to prevent the top flange 5 from coming off. Two locking pawls 34 are provided for the body portion 26 of the top flange 5. Specifically, an inner-side locking pawl 34A and a front-side locking pawl 34B are provided. The inner-side locking pawl 34A is constructed by a contact portion 36 which comes into contact with the locking projection 33 on the inner side, and a supporting bar portion 37 for supporting the contact portion 36. The contact portion 36 comes into contact with the locking projection 33 by using a surface facing to the front as a perpendicular contact face to thereby support the top flange 5 so as not to be deviated to the front side. The supporting bar portion 37 is formed so as to extend to the container body 2 side and also to the inner side.

The front-side locking pawl 34B is constructed by a contact portion 38 which comes into contact with the locking projection 33 on the front side and a supporting bar portion 39 for supporting the contact portion 38. The contact portion 38 comes into contact with the locking projection 33 by using a surface facing to the front side as a perpendicular contact face to thereby support the locking pawl 34B so as not to be deviated to the front side. The supporting bar portion 39 is formed so as to extend to the container body 2 side and also to the front side. By the supporting bar portion 39, the contact portion 38 is provided near to the container body 2 side more than the base end portion of the supporting bar portion 39. Accordingly, in the case where a force is applied to the top flange 5 in the direction of making the top flange 5 come off, the contact portion 38 is pressed strongly against the locking projection 33. Thus, even if a strong force is applied by an impact or the like, the contact portion 38 is reliably prevented from coming off from the locking projection 33. Accordingly, by the supporting bar portion 39, detachment of the top flange 5 is suppressed.

The guide rails 29 are members for performing positioning in a direction orthogonal to the sliding direction by guiding sliding of the top flange 5 supported to the container body 2 by the sliding and supporting means 27. The guide rails 29 are constructed by a fitting rail 29A and a receiving rail 29B. Two fitting rails 29A each constructed by one rail member are provided on the inner side of the two rails members of the supporting portion 30 in the side wall 2B of the container body 2. The receiving rail 29B is constructed by two rail members sandwiching the fitting rail 29A from both sides and is provided on the top flange 5 side opposite to the fitting rail 29A. The fitting rail 29A and the receiving rail 29B are provided in parallel with each other. Accordingly, the fitting rail 29A fits in the receiving rail 29B to support sliding from the front side to the inner side and sliding from the inner side to the front side of the top flange 5, thereby enabling the top flange 5 to be easily attached/detached to/from the container body 2.

As shown in Figs. 2 and 3, the handle 6 comprises two gripping rods 41 and 42. The gripping rods 41 and 42 are set at angles different from each other. Accordingly, the user selectively grips one of the two gripping rods 41 and 42 according to the orientation (portrait or landscape orientation) of the thin plate supporting container 1 at the time of carry. The angle of one of the gripping rods 41 and 42 is set to an angle which is optimum to the case where the thin plate supporting container 1 is carried longitudinally and the other angle is set to an angle which is optimum to the case where the thin plate supporting container 1 is carried transversely. Specific angles are properly set according to various conditions such as the size, weight, and the like of the thin plate supporting container 1. The handle 6 is detachably attached to each of the side walls 2C and 2D by an attaching/detaching mechanism having the same structure as that of the attaching/detaching mechanism 12.

The bottom plate 2E comprises legs 44 and a cover plate 45 as shown in Figs. 3 and 16. The legs 44 are members for supporting the container body 2. The legs 44 are constructed by proj ected bars formed along the overall width of two opposite sides of the bottom plate 2E. The cover plate 45 is a member for covering the lower side of the semiconductor wafers S housed in the container body 2. The cover plate 45 is provided so as to be curved downward between the legs 44. The cover plate 45 is set so that the gap "t" between the lower end of the semiconductor wafer S housed in the container body 2 and the cover plate 45 becomes a certain range, namely, the gap is set minimum so as to fully absorb the shock, for example, 3 mm for the following reason. Since the installation precision and supporting rigidity of the slotted plates 3 which will be described later have been improved, even in case of a strong impact due to a fall or the like of the thin plate supporting container 1, the semiconductor wafer S can be supported with sufficient strength and a downward deviation can be suppressed. In addition, the height of the container body 2 is decreased and the size is reduced only by an amount corresponding to the reduction in the gap between the bottom plate 2E and the lower end of the semiconductor wafer S. Consequently, when the thin plate supporting container 1 is packed, the gap between the bottom of the thin plate supporting container 1 and a packing box is increased as compared with the conventional case, so that cushioning can be increased and the capability of absorbing a shock due a fall or the like can be largely improved.

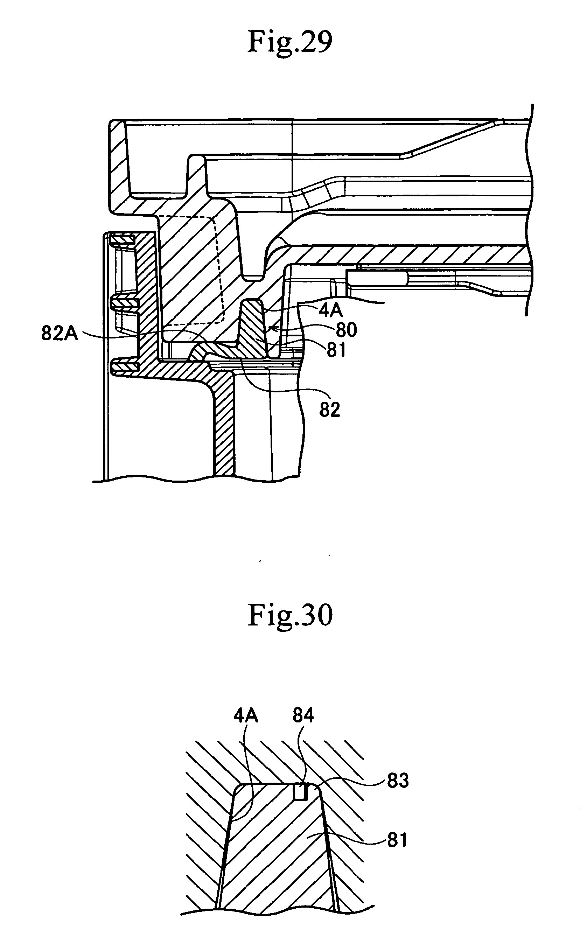

In an upper end portion of the container body 2, as shown in Fig. 1, a lid unit receiving step 47 with which the lid unit 4 fits is provided. The lid unit receiving step 47 is formed by enlarging the upper end portion of the container body 2 to the dimensions of the lid unit 4. The lid unit 4 is attached to the lid unit receiving step 47 by fitting with the inner side of a perpendicular plate portion 47A of the lid unit receiving step 47 and coming into contact with a horizontal plate portion 47B. Further, a gasket 80 (refer to Fig. 29) attached to the under face of the lid unit 4 comes into contact with the horizontal plate portion 47B, thereby keeping air tightness in the thin plate supporting container 1. On the inside of the perpendicular plate portion 47A of the lid unit receiving step 47, a fitting hole 48 is provided for fixing a special lid unit (not shown), used in the semiconductor fabricating process, to the container body 2 side. The fitting holes 48 are provided at four corners of the lid unit receiving step 47. The position and shape of the fitting hole 48 are properly set according to the special lid unit used in the semiconductor fabricating process.

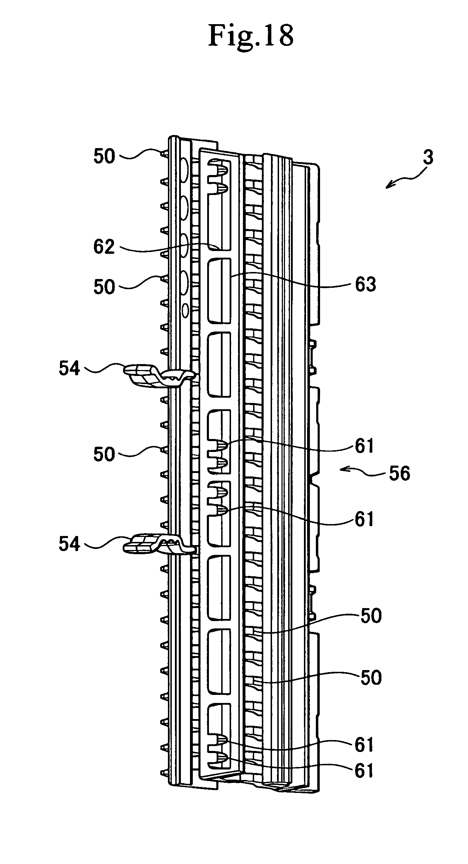

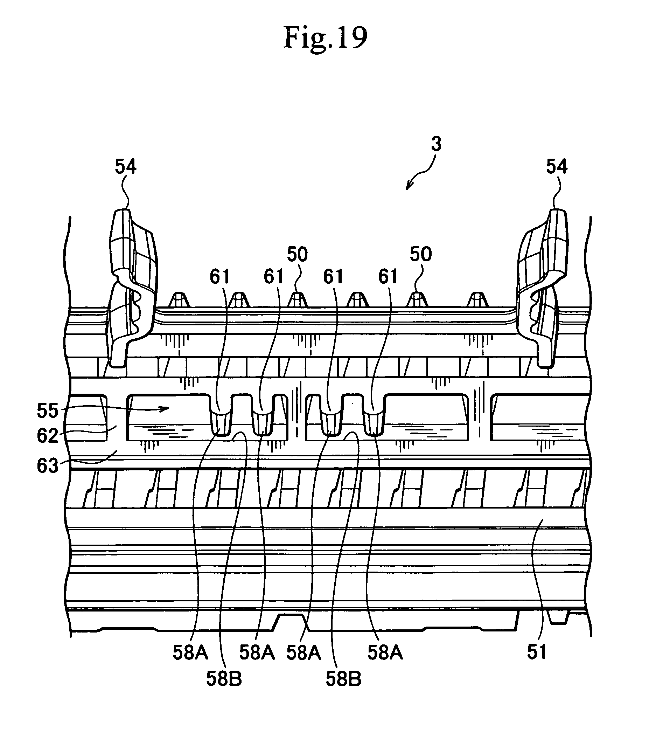

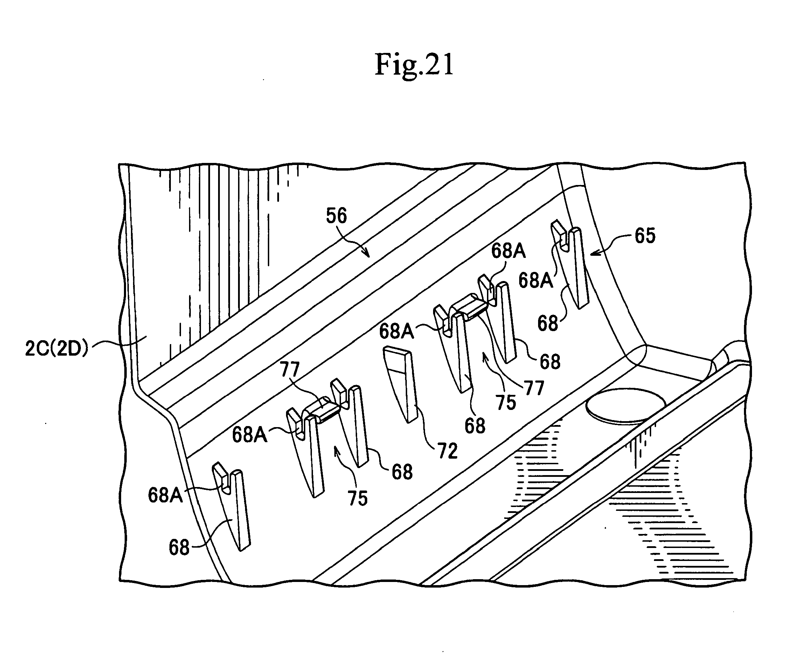

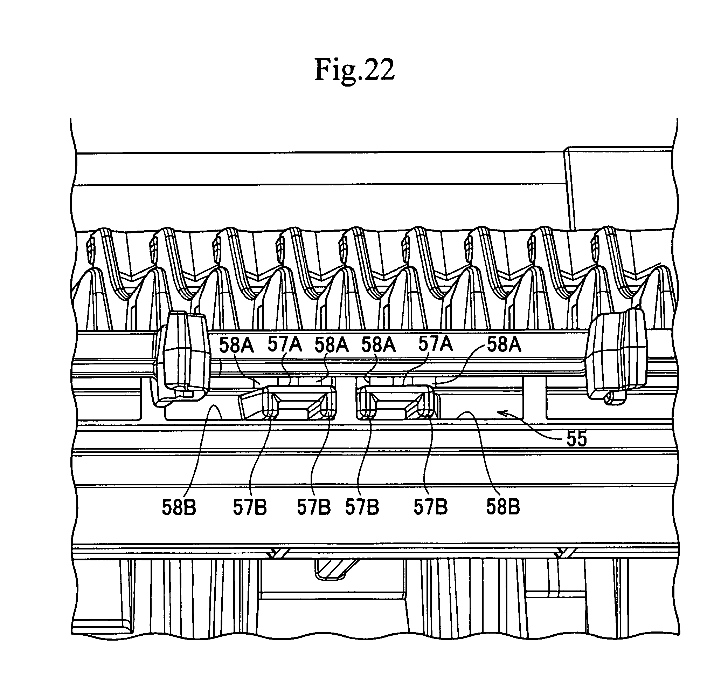

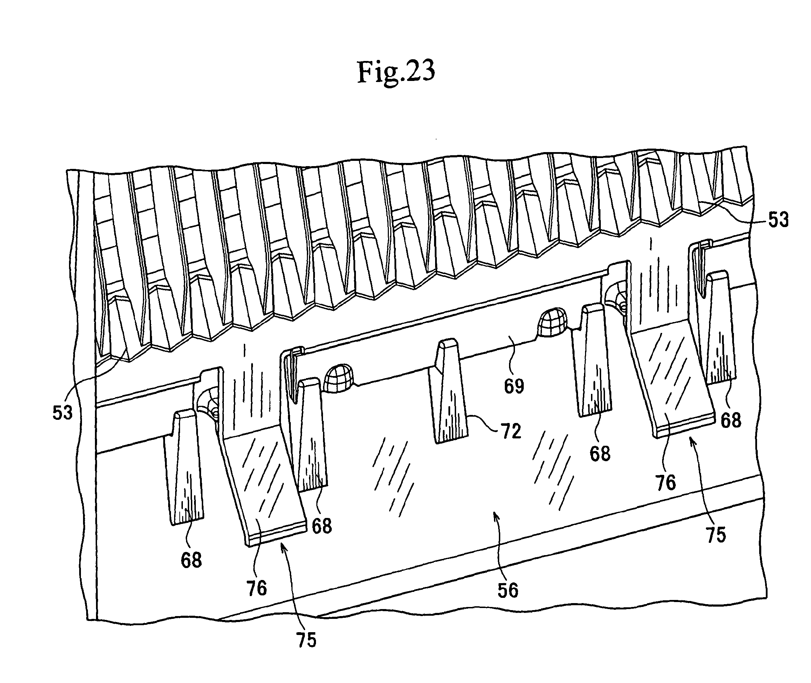

The slotted plate 3 is, as shown in Fig. 1 and Figs.16 to 23, a member for supporting the housed semiconductor wafers S from both sides. The slotted plate 3 is provided for each of the opposite side walls 2C and 2D in the container body 2. The slotted plate 3 is detachably attached to the inside of the container body 2. The slotted plate 3 is constructed mainly by a number of plate pieces 50 disposed in parallel at predetermined interval and supporting the wafers S one by one, and a supporting plate 51 for integrally supporting the plate pieces 50 in a state where the plate pieces 50 are disposed in parallel at predetermined intervals.

The plate piece 50 is provided so as to extend from the inner side of the container body 2 to an outlet/inlet port (opening 2F) of the semiconductor wafers S. The plate piece 50 is formed so that a portion from the inner side to an intermediate position is curved along the periphery of the semiconductor wafer S and a portion from the intermediate position to the outlet/inlet port is along the container body 2 side. On the inner side and the outlet/inlet port side in the plate piece 50, thin plate supporting projections 52 for supporting the semiconductor wafer S are provided. The thin plate supporting projection 52 on the outlet/inlet portion side is provided around an intersecting point of the inner periphery of the plate piece 50 and the periphery of the semiconductor wafer S. By providing the thin plate supporting projection 52 close to the outlet/inlet port as much as possible, the semiconductor wafer S is stable supported.

Between the plate pieces 50 on the inner side, a V-shaped groove 53 is provided. When the container body 2 is placed longitudinally, the semiconductor wafer S is fit into the V-shaped groove 53 and comes into contact with the bottom portion of the V-shaped groove 53. The semiconductor wafer S is supported in a center portion.

Two handles 54 are provided on upper portion of the slotted plate 3. The handles 54 are portions grabbed by the user to lift the slotted plate 3. The slotted plate 3 is lifted by taking the two handles 54 between the user's fingers.

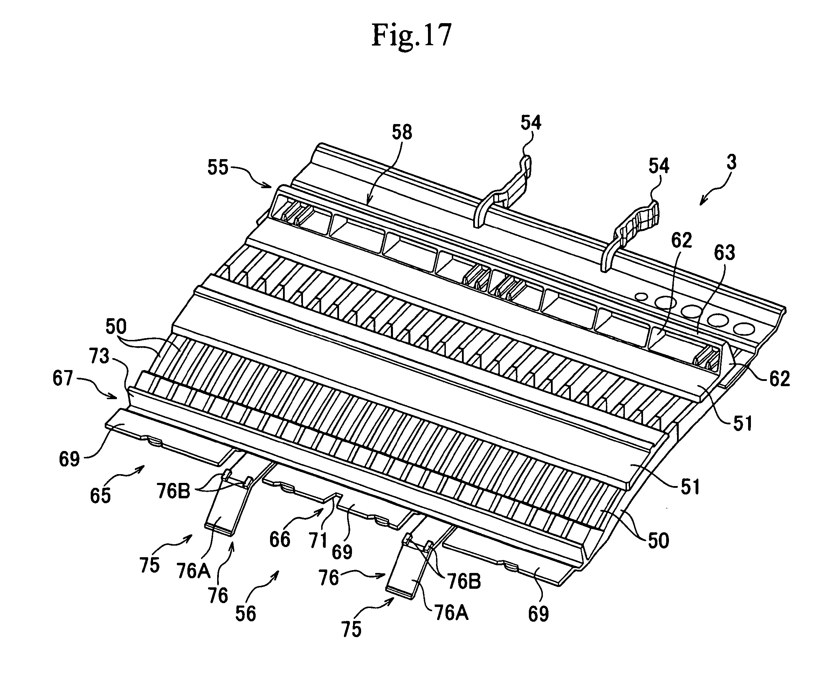

The supporting plates 51 are provided in three positions, innermost side (lower left side in Fig. 17), an intermediate portion, and an inlet side (upper right side in Fig. 17) of each plate piece 50, and integrally support the plate pieces 50.

The slotted plate 3 is detachably fixed to each of the side walls 2C and 2D which face each other in the container body 2 by an upper fitting portion 55 and a lower fitting portion 56.

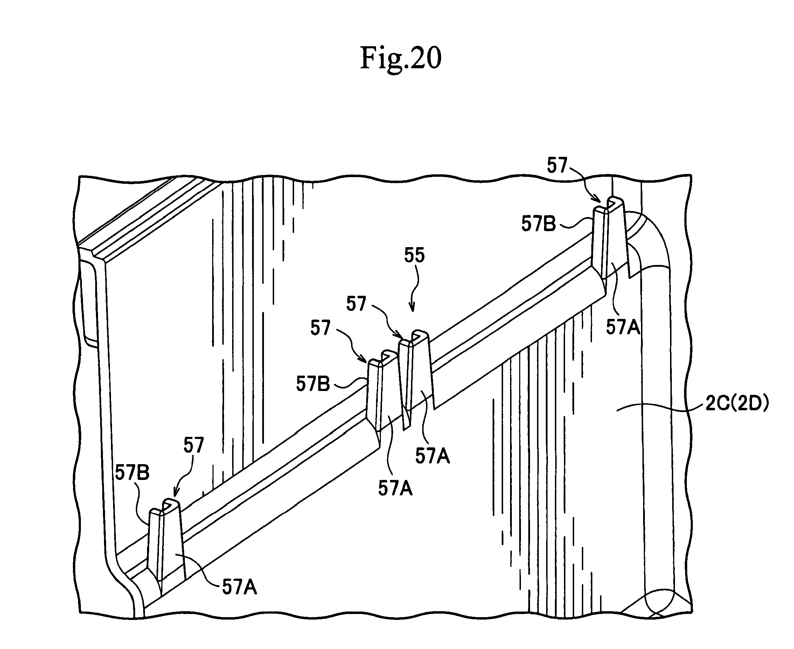

The upper fitting portion 55 is a member for supporting the upper portion of the slotted plate 3 to the container body 2. The upper fitting portion 55 is constructed by an upper fitting piece 57 and an upper receiving piece 58. The upper fitting piece 57 is provided for each of the side walls 2C and 2D which face each other in the container body 2. A step 59 is provided in an intermediate position in the vertical direction of each of the side walls 2C and 2D. In the step 59, the four upper fitting pieces 57 are provided. It is sufficient to provide two upper fitting pieces 57 at both ends. According to the size of the slotted plate 3 or the like, three or five or more upper fitting pieces 57 may be provided. The upper fitting piece 57 is formed in a U shape in plan view. The U-shaped upper fitting piece 57 includes a contact face 57A and a supporting face 57B. The contact face 57A is a part having a flat face shape which comes into contact with the slotted plate 3 side to perform positioning of the slotted plate 3 in the longitudinal direction (the direction from the left inner side to the right front side in Fig. 20) while preventing turn of the slotted plate 3. Since the slotted plate 3 is positioned in the longitudinal direction by using the contact face 57A as a reference, the contact face 57A is formed in accurate position and dimensions. The supporting face 57B is a part for maintaining a state where the contact face 57A is in contact with the slotted plate 3 side.

The upper receiving piece 58 is a member which fits with the upper fitting piece 57 to perform positioning in the longitudinal direction of the slotted plate 3. The upper receiving piece 58 is provided in a position facing the upper fitting piece 57 in the slotted plate 3. Specifically, the upper receiving piece 58 is constructed by a face 58 to be contacted and a face 58B to be supported. The face 58A to be contacted is a part with which the contact face 57A of the upper fitting piece 57 comes into contact to perform positioning of the slotted plate 3 in the longitudinal direction while suppressing turn of the slotted plate 3. The face 58A to be contacted is formed in a flat face shape and suppresses turn between the face 58A and the upper fitting piece 57. The face 58A to be contacted is formed at the tip of a projected bar 61 provided in a position corresponding to the contact face 57A of the fitting piece 57 in the slotted plate 3. The contact face 58A of the projected bar 61 comes into contact with the contact face 57A of the upper fitting piece 57, thereby positioning the slotted plate 3 in the longitudinal direction. In this example, two projected bars 61 come into contact with the contact face 57A of one upper fitting piece 57. The reason why the shape of the projected bar 61 is used is to prevent shrink at the time of molding and improve dimensional precision.

The face 58B to be supported is a member which comes into contact with the supporting face 57B of the upper fitting piece 57 to thereby support the contacted face 58A in a state where the contacted face 58A is in contact with the contact face 57A of the upper fitting piece 57. The face 58B to be supported is formed on the rear face of a band-shaped plate member 63 supported on the slotted plate 3 side by a plurality of supporting plate pieces 62. The overall width of the plate member 63 serves as the face 58B to be supported. The supporting face 57B can come into contact with the plate member 63 in any position and can support the slotted plate 3.

The contact faces 57A and 58A are in contact with each other while being supported by the supporting faces 57A and 57B, thereby preventing deformation such as deflection of the slotted plate 3 due to turn of the supporting portion of the slotted plate 3 and enabling accurate positioning in the longitudinal direction of the slotted plate 3 to be performed. In the upper fitting portion 55, only positioning in the longitudinal direction of the slotted plate 3 is performed. Positioning in the other direction is carried out by the lower fitting portion 56.

The lower fitting portion 56 is a member for supporting a lower portion of the slotted plate 3 to the container body 2 side. The lower fitting portion 56 has a vertical-direction positioning means 65 for performing positioning in the vertical direction of the slotted plate 3, a horizontal-direction positioning means 66 for performing positioning in the horizontal direction, and a front/rear direction positioning means 67 for performing positioning in the front/rear direction. By the means, the lower portion of the slotted plate 3 is accurately positioned in the vertical, horizontal, and front/rear directions and, also in cooperation with the upper fitting portion 55, the slotted plate 3 is accurately positioned and fixed to the container body 2.

The vertical-direction positioning means 65 is constructed by a vertical-direction supporting piece 68 and a lower plate 69.

The vertical-direction supporting piece 68 is a member which is provided in the lower portion of each of the side walls 2C and 2D facing each other in the container body 2, fits in the lower portion of the slotted plate 3 and comes into contact with the lower end of the slotted plate 3, thereby positioning the slotted plate 3 in the vertical direction. The vertical-direction supporting piece 68 has a fitting notch 68A which fits with the slotted plate 3. The dimension in the vertical direction of the fitting notch 68A is accurately set to position the slotted plate 3 in the vertical direction.

The lower plate 69 is a member for accurately positioning the slotted plate 3 in the vertical direction by fitting with the fitting notch 68A of the vertical-direction supporting piece 68. The lower plate 69 is a plate member extended downward from the lower portion of the slotted plate 3. Since the lower end face of the lower plate 69 is a part which fits with and in direct contact with the fitting notch 68A, the dimension in the vertical direction is accurately set.

The horizontal-direction positioning means 66 is constructed by a notch 71 and a horizontal-direction supporting piece 72.

The notch 71 is provided as a notch which opens downward in the lower plate 69 of the slotted plate 3.

The horizontal-direction supporting piece 72 is a member which is provided between the vertical-direction supporting pieces 68 in each of the lower portions of the side walls 2C and 2D facing each other in the container body 2 and is fit in the notch 72 in the lower portion of the slotted plate 3, thereby positioning the slotted plate 3 in the horizontal direction. The horizontal-direction supporting piece 72 is formed in a wedge shape which is fit in the notch 71. By the fitting of the horizontal-direction supporting piece 72 to the notch 71, the slotted plate 3 is positioned accurately in the horizontal direction.

The front/rear-direction positioning means 67 is constructed by a front/rear-direction supporting plate piece 73. The front/rear-direction supporting plate piece 73 is made of a band-shaped plate member. The front/rear-direction supporting plate piece 73 made of a band-shaped plate member is provided below the slotted plate 3 so as to extend horizontally to the back side of the slotted plate 3 and come into contact with the lower portion of each of the side walls 2C and 2D of the container body 2, thereby positioning the slotted plate 3 in the front/rear direction.

A stopper 75 is provided in the lower portion of the slotted plate 3. The stopper 75 is a member for stopping disengagement to the up of the slotted plate 3. The stopper 75 is constructed by a locking piece 76 and a locking projection 77. The locking piece 76 is constructed by a band-shaped elastic plate piece 76A extended downward from the lower end of the slotted plate 3 and a locking pawl 76B provided on the locking projection 77 side of the elastic plate piece 76A. The locking projection 77 is a member to be locked by the locking pawl 76B of the locking piece 76. The locking pawl 76B of the locking piece 76 provided between the vertical-direction supporting pieces 68 of each of the side walls 2C and 2D fits with the locking projection 77, thereby preventing the slotted plate 3 from coming off to the above.

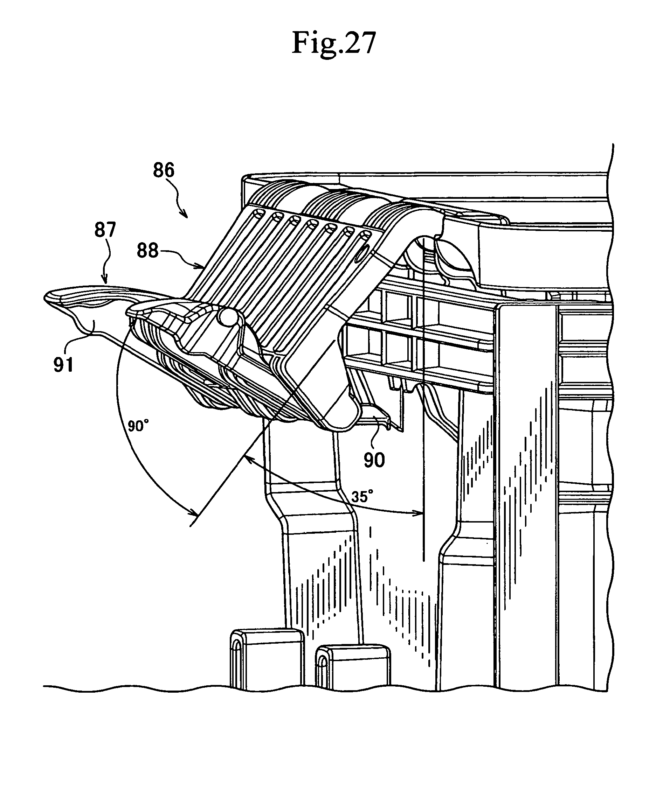

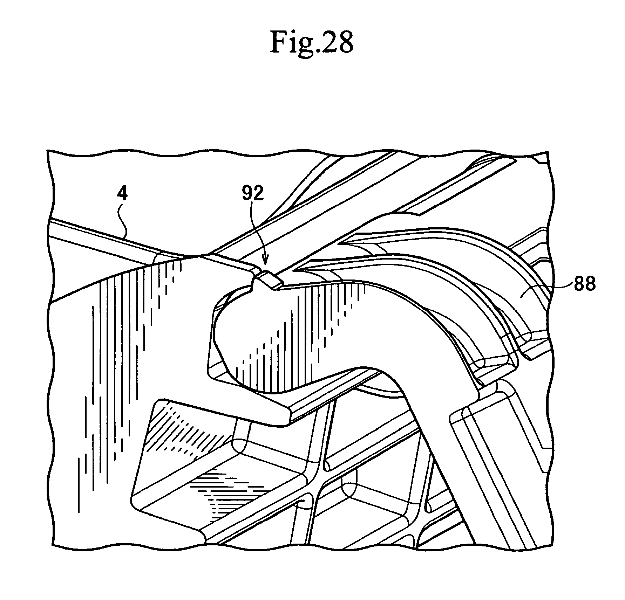

The lid unit 4 is structured as shown in Fig. 2 and Figs. 27 to 30. The lid unit 4 is formed in a saucer shape which is open upward.

The gasket 80 is provided between the lid unit 4 and the container body 2. The gasket 80 is constructed by a base end supporting portion 81 and a contact portion 82.

The base end supporting portion 81 is a part which is fit in the fitting groove 4A on the lid unit 4 side to support the whole. The base end supporting portion 81 has an almost trapezoid shape in cross section. On the inside of the upper surface of the base end supporting portion 81, a seal piece 83 and an annular groove 84 are provided. The seal piece 83 extends upward and comes into contact with the lid unit 4 side to keep air tightness. The annular groove 84 is provided on the outer side of the seal piece 83 and absorbs elastic deformation of the seal piece 83.

The contact portion 82 is formed by being expanded from the base end supporting portion 81 into a flange shape. The contact portion 82 has a shape such that its intermediate portion is swollen upward (to the lid unit 4 side) and its outer periphery is folded downward (to the container body 2 side), in cross section. The portion 82A swollen upward in the contact portion 82 serves as a portion pressed by the lid unit 4, and the periphery is a portion which comes into contact with the container body 2 side. Accordingly, the intermediate portion to be pressed is pressed by the lid unit 4 in a state where the periphery is in contact with the container body 2 side, and the periphery is closely attached to the container body by elastic force of the contact portion 82.

To the sides facing the side walls 2C and 2D of the container body 2, of the lid unit 4, a latch mechanism 86 is provided. The latch mechanism 86 is a mechanism for fixing the lid unit 4 to the container body 2. The latch mechanism 86 is constructed by a first arm 87 and a second arm 88. The first arm 87 is a member for fixing the lid unit 4 to the container body 2 by directly being locked by a receiving portion (not shown) on the container body 2 side. The second arm 88 is a member which is swingably supported by the lid unit 4 and swingably supports the first arm 87.

The first arm 87 has a locking pawl 90 and a grip 91. The looking pawl 90 is provided for the base end portion and comes into contact with the receiving portion on the container body 2 side to thereby fix the lid unit 4 to the container body 2 side. The grip 91 is a member for lifting the lid unit 4. The grip 91 is formed at the tip of the first arm 87, in a shape which is easily gripped by a hand. The first and second arms 87 and 88 are set in a position in a side of the lid unit 4 so that the grip 91 is easily gripped in a state where each of the first and second arms 87 and 88 swing to each limit. It is also set that, in a state where the first and second arms 87 and 88 swing to the limit, the locking pawl 90 of the base end of the first arm 87 does not come into contact with the container body 2. Specifically, the first arm 87 is open up to 90° with respect to the second arm 88 and the second arm 88 is open up to 35° with respect to the container body 2. The first arm 87 is supported at 90° while its tip side is in contact in a state where the base end portion is pivoted by the L-shaped second arm 88. The second arm 88 is supported at 35° by a stopper 92.

On the back face of the lid unit 4, a thin plate pressing member 94 is provided. The thin plate pressing member 94 is a member for pressing and supporting the upper portion of the semiconductor wafer S housed in the container body 2 when the lid unit 4 is attached to the container body 2.

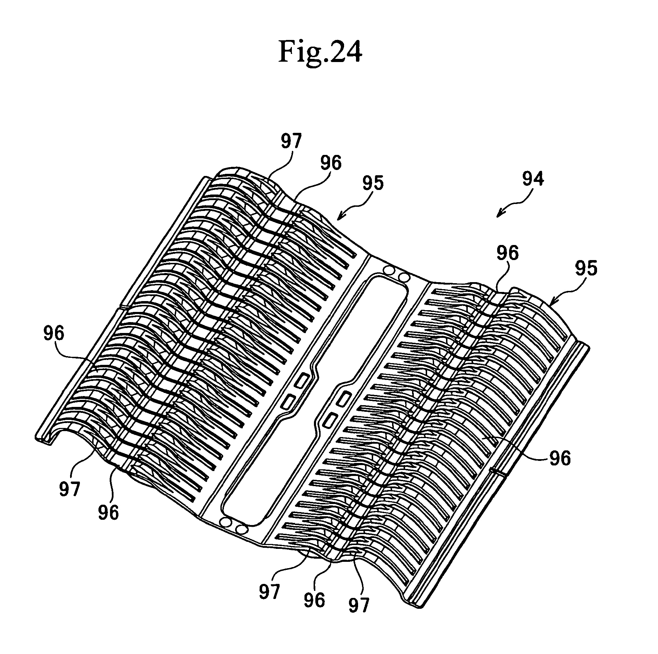

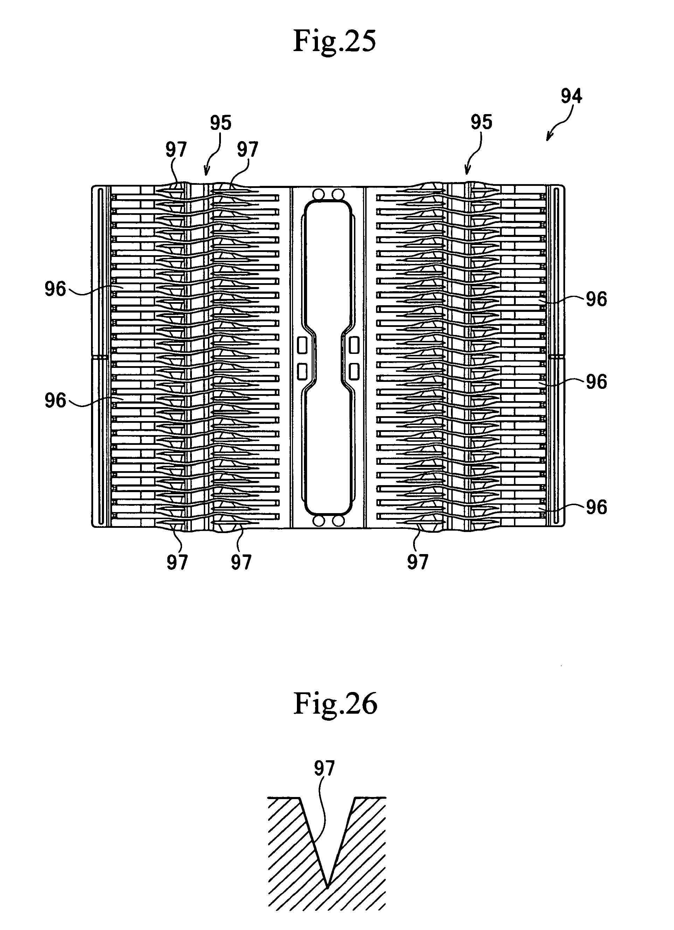

The thin plate pressing member 94 is formed in an almost rectangular shape as shown in Figs. 24 to 26. Both ends in the longitudinal direction and the center portion of the thin plate pressing member 94 are fixed to the back face of the lid unit 4, and the portions between the both ends and the center portion serve as pressing portions 95. The pressing portion 95 is a member for elastically pressing and supporting the upper portion of the semiconductor wafer S and is constructed by a number of pressing bands 96 arranged in parallel. The pressing band 96 is an elastic member and is formed so as to be curved downward. Further, the pressing band 96 is formed in a wave shape in plan view (the shape in the state of Fig. 25) along the periphery of the semiconductor wafer S to prevent the semiconductor wafer S from entering the gap between the pressing bands 96.

The shape of a side face of the pressing band 96 is an inverted mountain shape. In two apex positions of the mountain-shaped portion, fitting grooves 97 for supporting each semiconductor wafer S are provided at predetermined intervals. The fitting groove 97 is formed at an acute angle so as to sandwich the periphery of the semiconductor wafer S.

### [Operation]

The thin plate supporting container 1 constructed as described above is used as follows.

In a state where a number of semiconductor wafers S are inserted in the container body 2 and the lid unit 4 is attached, the thin plate supporting container 1 is transported to a semiconductor fabricating factory or the like. The lid unit 4 is detached from the thin plate supporting container 1 carried in the semiconductor fabricating factory or the like, a special lid unit for the semiconductor fabricating factory or the like is attached to the thin plate supporting container 1 and the resultant is carried into a fabricating process.

The upper portion of the slotted plate 3 attached in the container body 2 is supported by the upper fitting portion 55. The upper fitting piece 57 fits with the upper receiving piece 58 of the slotted plate 3. Accordingly, when the contact face 57A comes into contact with the face 58A to be contacted in a state where the supporting face 57B of the upper fitting piece 57 is in contact with the face 58B to be supported of the upper receiving piece 58, the upper portion of the slotted plate 3 is securely supported on the container body 2 side. Consequently, the slotted plate 3 does not swing and is securely supported in the supporting portion, and positioning in the front/rear direction of the slotted plate 3 is performed. In such a manner, deformation such as deflection of the slotted plate 3 is repressed and the slotted plate 3 is supported in an accurate position.

The lower portion of the slotted plate 3 is supported by the lower fitting portion 56.

First, the slotted plate 3 is positioned in the vertical direction by the vertical-direction positioning means 65. The lower end face of the lower plate 69 of the vertical-direction positioning means 65 fits in the fitting notch 68A of the vertical-direction supporting piece 68, thereby accurately positioning of the slotted plate 3 in the vertical direction is performed.

In this case, the notch 71 on the slotted plate 3 side of the horizontal-direction positioning means 66 fits with the horizontal-direction supporting piece 72 on the container body 2 side, thereby positioning the slotted plate 3 in the horizontal direction.

Further, the front/rear-direction supporting piece 73 of the front/rear-direction positioning means 67 comes into contact with the lower portion of each of the side walls 2C and 2D of the container body 2 to perform positioning of the slotted plate 3 in the front/rear direction.

At this time, the locking piece 76 of the stopper 75 fits with the locking projection 77 to support the slotted plate 3 so as not to come off to the above.

The slotted plate 3 can be thereby accurately positioned with the upper fitting portion 55 and the lower fitting portion 56 and easily fixed. In the case of detaching the slotted plate 3, the locking piece 76 is pulled to the front side to move the slotted plate 3 upward. It enables the slotted plate 3 to be easily detached.

The plate piece 50 of the slotted plate 3 is formed so that a portion from the inner side to an intermediate position is curved along the periphery of the semiconductor wafer S and a portion from the intermediate position to the outlet/inlet port is formed along the container body 2 side. Thus, the semiconductor wafer S can be smoothly inserted/taken in/out the container body 2 and can be prevented from coming into contact with the plate piece 50.

The thin plate supporting projection 52 for supporting the semiconductor wafer S is provided on each of the inner side and outlet/inlet side of the plate piece 50, and the thin plate supporting projection 52 on the outlet/inlet port side is provided around the intersection between the inner periphery of the plate piece 50 and the periphery of the semiconductor wafer S, so that the semiconductor wafer S inserted in the container body 2 can be stably supported.

The upward swollen portion 82A of the contact portion 82 is pressed with the lid unit 4 in a state where the lid unit 4 is attached to the container body 2 so that the periphery of the gasket 80 of the lid unit 4 is closely attached to the container body 2 side. Consequently, even when the gasket 80 is deflected and a gap occurs between the gasket 80 and the container body 2, the peripheral portion can be closely attached to the container body 2 side with reliability. In such a manner, the container body 2 is sealed with the gasket 80.

In the base end supporting portion 81, the seal piece 83 comes into contact with the lid unit 4 side and elastic deformation caused by the contact of the seal piece 83 is absorbed by the annular groove 84 to keep air tightness between the gasket 80 and the lid unit 4. Further, the upward swollen portion 82A of the contact portion 82 is also closely attached to the lid unit 4 to keep air tightness between the gasket 80 and the lid unit 4.

Since the gap between the cover plate 45 for the container body 2 and the lower end of the semiconductor wafer S housed in the container body 2 is set minimum so as to fully absorb the shock, the size of the container body 2 is reduced. When the size of the container body 2 is reduced, the size of the thin plate supporting container 1 itself is accordingly reduced. Consequently, when packed, the gap between the bottom of the thin plate supporting container 1 and a packing carton increases. The cushioning material in the larger gap can be also increased, and the shock absorbing capability in case of a shock of a fall or the like can be largely improved.

In the attaching/detaching mechanism 12 for supporting the top flange 5 and the handle 6 for carry, at the time of attaching the top flange 5 or the like, the receiving rail 29B engages with the fitting rail 29A, the sliding portion 31 is fit in the supporting portion 30, and the top flange 5 or the like is slid to the inner side. Thereby the contact portion 36 of the inner-side locking pawl 34A is locked by the locking projection 33 and the contact portion 38 of the front-side locking pawl 34B is locked by the locking projection 33. In such a manner, the top flange 5 or the like can be easily attached.

At the time of detachment, the supporting bar portion 39 of the front-side locking pawl 34B is lifted with the user's finger to come off the contact portion 38 from the locking projection 33, and the top flange 5 or the like is shifted to the front side. In such a manner, the top flange 5 or the like can be easily detached.

Since the supporting portion 30 and the sliding portion 31 are set in such a manner that the interval is narrow on the front side and is wide on the inner side, so that the sliding portion 31 can easily fit with the supporting portion 30.

Since the top flange 5 or the like is supported by the fitting rails 29A and the receiving rails 29B, the top flange 5 can be smoothly moved and easily attached/detached.

In the case where a strong force is applied in the direction of making the top flange 5 or the like come off by an abnormal shock of a fall or the like of the thin plate supporting container 1 in a state where the top flange 5 or the like is attached, by the support of the supporting bar portion 39 on the front-side locking pawl 34B side, the top flange 5 or the like is prevented from coming off. Since the contact portion 38 of the front-side locking pawl 34B is provided to the container body 2 side as the other member side than the base end portion of the supporting bar portion 39, the contact portion 38 is pressed in the direction of strongly pressed against the locking projection 33 and does not come off. Thus, even when a strong force is applied to the flange 5 or the like due to a shock or the like, the contact portion 38 does not come off from the locking projection 33, and the supporting bar portion 39 supports the top flange 5 or the like with reliability to prevent the top flange 5 or the like from coming off.

In the latch mechanism 86, at the time of attaching the lid unit 4 to the container body 2, the user grips the grip 91 of the first arm 87 to lift the lid unit 4 up and covers the container body 2 with the lid unit 4 from above. At the time, since the first arm 87 is set at 90° with respect to the second arm 88 and the second arm 88 is set at 35° with respect to the container body 2, the grip 91 is positioned on a side of the lid unit 4 in a state where the first and second arms 87 and 88 swing to each limit, and the grip 91 is in the position at which the user can easily lift the lid unit 4 in an optimum state. By gripping the grip 91, the user covers the container body 2 with the lid unit 4. By still gripping the grip 91, the grip 91 is pushed downward. The locking pawl 90 in the base end portion of the first arm 87 comes into contact with the container body 2 side and the lid unit 4 is fixed to the container body 2.

In the case of detaching the lid unit from the container body, a user grips the grips 91 of the first arms 87 and pulls the grips 91 to the opposite sides. The locking pawl 90 in the base end portion of the first arm 87 is detached from the container body 2 side and the lid unit 4 is disengaged. The user still grips the grips 91 to lift the lid unit 4. At this time, the locking pawl 90 in the base end portion swings to a position in which it does not come into contact with the container body 2 in a state where the second arm 88 makes the first arm 87 swing to the limit. Consequently, even when the user lifts the lid unit 4 up, the locking pawl 90 does not come into contact with the container body 2, and the lid unit 4 can be easily detached.

As described above, the grip 91 is supported in a position in which it is easily gripped on a side of the lid unit 4, and the locking pawl 90 is open to the position where it does not come into contact with the container body 2. Thus, the lid unit 4 can be easily attached/detached.

The semiconductor wafer S fit in the fitting groove 97 of the thin plate pressing member 94 is supported by being fit in the fitting groove 97 formed at an acute angle. When the fitting groove 97 is formed at an acute angle, the periphery of the semiconductor wafer S is fit in the fitting groove 97 and is securely supported. Therefore, even when a strong shock is applied to the thin plate supporting container 1, the periphery of the semiconductor wafer S is caught in the fitting groove 97 and is securely supported while preventing rotation and a shift of the semiconductor wafer S.

Since the pressing band 96 is formed in a wave shape along the peripheries of the semiconductor wafers S, even if the semiconductor wafer S comes off from the fitting groove 97, the semiconductor wafer S does not enter the gap between the pressing bands 96.

Since the V-shaped groove plate piece 15 is detachably attached to the supporting stand 16 in the body positioning means 11, irrespective of the material of the container body 2, the V-shaped groove plate piece 15 cab be made of a material by which the fitting projection of the mounting stand in the semiconductor fabricating process easily slides. When the fitting projection of the mounting stand used in the semiconductor fabricating process is fit in the fitting groove 13 of the body positioning means 11 by the V-shaped groove plate piece 15 made of a material having low surface friction resistance, smooth sliding is achieved and the thin plate supporting container 1 can be accurately positioned.

Since the V-shaped groove plate piece 15 can be detachably attached to the supporting stand 16, it can be easily replaced in accordance with the material of the projection on the opposite side.

### [Modifications]

(1) Although the gasket 80 is provided on the lid unit 4 side in the foregoing embodiment, it can be provided on the container body 2 side. In this case as well, functions and effects similar to those of the embodiment can be obtained.
(2) Although four upper fitting pieces 57 of the upper fitting portion 55 are provided in the embodiment, it is sufficient to provide at least two upper fitting pieces 57 at both ends. The number of the upper fitting pieces 57 is properly set according to the size, requested strength, and the like. In this case as well, functions and effects similar to those of the foregoing embodiment can be obtained.
(3) Although two sliding and supporting means 27 are provided in the foregoing embodiment, three or more sliding and supporting means may be provided. Although two guide rails 29 are provided, one guide rail 29 or three or more guide rails 29 may be provided. In this case as well, functions and effects similar to those of the foregoing embodiment can be obtained.
(4) Although the supporting stand 16 of the body positioning means 11 is formed so as to construct a part of the fitting groove 13 in the foregoing embodiment, the supporting stand 16 may be also formed so as to construct the whole fitting groove 13.

As described above in detail, the thin plate supporting container of the invention produces the following effects.
(1) The upper fitting piece has a contact face having a flat plane shape which comes into contact with the slotted plate side to thereby position the slotted plate in the front/rear direction while preventing swing of the slotted plate, and a supporting face for supporting the contact face in a state where the contact face is in contact with the slotted plate side, and the upper receiving piece has a face to be contacted having a flat plane shape which comes into contact with the contact face of the upper fitting piece to thereby position the slotted plate in the front/rear direction while preventing swing of the slotted plate, and a face to be supported which comes into contact with the supporting face of the upper fitting piece to thereby support the face to be contacted in a state where the face to be contacted is in contact with the contact face of the opposite side. Accordingly, the slotted plate can be supported with reliability without and accurately positioned in the front/rear direction while suppressing swing of the slotted plate. Thus, deformation such as a deflection of the slotted plate is prevented and the slotted plate can be supported in an accurate position.
(2) The upper fitting portion for supporting an upper portion of the slotted plate to the container body side, and the lower fitting portion for supporting a lower portion of the slotted plate to the container body side are provided. The lower fitting portion has: a vertical-direction positioning means for positioning the slotted plate in the vertical direction; horizontal-direction positioning means for performing positioning in the horizontal direction; and a front/rear-direction positioning means for performing positioning in the front/rear direction. Consequently, the lower portion of the slotted plate can be accurately positioned and supported.
(3) The vertical-direction positioning means has a vertical-direction supporting piece which is provided in a lower portion of each of side walls facing each other in the container body and is fit in a lower portion of the slotted plate, and comes into contact with a lower end of the slotted plate, thereby performing positioning in the vertical direction of the slotted plate. Thus, the lower portion of the slotted plate can be accurately positioned in the vertical direction and supported.
(4) The horizontal-direction positioning means has a notch formed in a lower portion of the slotted plate, and a horizontal-direction supporting piece which is provided in a lower portion of each of side walls facing each other in the container body, fits with the notch in the lower portion of the slotted plate. Thus, the lower portion of the slotted plate can be accurately positioned in the vertical direction and supported.
(5) The front/rear direction positioning means has a front/rear direction supporting piece which is provided so as to extend from the lower portion of the slotted plate to a back side of the slotted plate, and fits with the lower portion of a side wall face of the container body. Consequently, the lower portion of the slotted plate can be accurately positioned in the front/rear direction and supported.
(6) A stopper for stopping disengagement to the above of the slotted plate by being locked to the container body side is provided in a lower portion of the slotted plate. Thus, the slotted plate can be supported so as not to be disengaged to the above.
(7) The slotted plate is constructed by arranging a plurality of plate pieces for supporting the plurality of thin plates one by one, the plate piece is extended from an inner side of the container body to an outlet/inlet port of the thin plate and is formed so that a portion from the inner side to an intermediate position is curved along the periphery of the thin plate and a portion from the intermediate position to the outlet/inlet port is along the container body side, on the inner side and the outlet/inlet port side in the plate piece, thin plate supporting projections for supporting the thin plates are provided, and the thin plate supporting projection on the outlet/inlet port side is provided around an intersecting point of an inner periphery of the plate piece and the periphery of the thin plate. Consequently, a thin plate can be stably supported by the thin plate supporting projections provided on the inner side and the outlet/inlet port side.
(8) A gasket is provided between the lid unit and the container body, the gasket has a base end supporting portion for supporting the whole by being fit to the lid unit side or container body side, and a contact portion formed so as to extend from the base end supporting portion, the contact portion is formed by being expanded from the base end supporting portion into a flange shape, making its intermediate portion swollen upward, and making an outer periphery folded downward, and the intermediate portion is pressed against the lid unit side or the body side in a state where the periphery is in contact with the container body side or the lid unit side, thereby making the periphery closely attached to the container body side or the lid unit side by elastic force of the contact portion. Thus, air tightness between the lid unit and the container body can be improved.
(9) The thin plate supporting container further includes: a seal piece which is provided on the inner side of an upper surface of a base end supporting portion of the gasket, is extended upward, and comes into contact with the lid unit side or container body side; and an annular groove provided on the outer side of the seal piece and absorbing elastic deformation of the seal piece. Thus, air tightness between the gasket and the lid unit can be improved.
(10) A bottom plate of the container body is set so that a gap between the bottom plate and the lower end of the thin plate housed in the container body is set minimum so as to fully absorb the shock. Therefore, the height of the container body can be reduced.
(11) Since the height of the container body is reduced only by an amount corresponding to reduction in the gap between the bottom plate of the container body and the lower end of the thin plate housed in the container body, the size of the thin plate supporting container can be reduced. Consequently, cushioning used at the time of packing can be increased, and impact absorbing capability in the case of an impact can be largely improved.
(12) A locking means of an attaching/detaching mechanism has a locking projection provided for the one of members or the other member, and a locking pawl provided for the other or one of members, the locking pawl is constructed by a contact portion which comes into contact with the locking projection and a supporting bar portion for supporting the contact portion, and the supporting bar portion is formed so as to extend to the other-side member and to the front side of the sliding and supporting means. With the structure, the top flange or the like can be prevented from coming off due to an impact.
(13) Since the contact portion of the locking pawl is provided on the side of the other-side member than the base end portion of the supporting bar portion, the contact portion does not come off from the locking projection and the top flange or the like can be prevented from coming off due to an impact.
(14) Two supporting portions and two sliding portions of the sliding and supporting means are provided in parallel, and each of the interval between the supporting portions and the interval between the sliding portions is set to be small on the front side and to be large on the inner side. Thus, the sliding portion can be easily fit in the supporting portion.
(15) Since guide rails for guiding two members supported by the sliding and supporting means so as to slide and performing positioning in a direction orthogonal to the sliding direction are provided, by being guided by the guide rails, the top flange or the like can be easily attached/detached.
(16) A latch mechanism is constructed by a first arm locked to the container body side to fix the lid unit to the container body, and a second arm swingably supported by the lid unit and swingably supporting the first arm, the first arm is constructed by a locking pawl which is provided in a base end portion of the first arm and comes into contact with the container body side, and a grip which is provided at a tip portion and is positioned in a side of the lid unit in a state where the first and second arms swing to the limit, and the second arm swings to a position where the locking pawl of the base end portion of the first arm does not come into contact with the container body in a state where the first arm swings to the limit. With the structure, the lid unit can be easily attached/detached to/from the container body.
(17) The first arm is open up to 90° with respect to the second arm and the second arm is open up to 35° with respect to the container body. Therefore, the first arm can be prevented from coming into contact with the container body and the grip can be supported in a side of the lid unit and is in a position at which the grip is easily gripped.
(18) A thin plate pressing member is provided on the back face of the lid unit, the thin plate pressing member for supporting thin plates by pressing an upper portion of a thin plate housed in the container body when the lid unit is attached to the container body, fitting grooves in each of which the thin plate is fit and supported are provided for the thin plate pressing member, and the fitting groove is formed at an acute angle so as to catch the periphery of the thin plate. Therefore, a thin plate can be supported with reliability.
(19) A thin plate pressing member is provided on the back face of the lid unit, the thin plate pressing member for supporting thin plates by pressing an upper portion of a thin plate housed in the container body when the lid unit is attached to the container body, the thin plate pressing member has a number of pressing bands which are arranged in parallel, comes into contact with the periphery of the thin plate, and supports the thin plates at predetermined intervals one by one, and the pressing bands are formed in a wave shape along the peripheries of the thin plates. Thus, a thin plate can be prevented from entering the gap between the pressing bands.
(20) Body positioning means for positioning the whole container body is provided on the bottom of the container body disposed transversely, and the body positioning means includes V-shaped groove plate pieces constructing V-shaped grooves provided in three positions in three directions on the bottom of the container body, and supporting stands for supporting the V-shaped groove plate pieces. Therefore, a V-shaped groove plate piece made of a material different from that of the container body can be attached.
(21) Since the V-shaped groove plate piece is made of a material having low surface friction resistance, the projection on the mounting stand smoothly slides on the V-shaped groove plate piece and the thin plate supporting container can be accurately positioned.
(22) Since the V-shaped groove plate piece is detachably attached to the supporting stand, the V-shaped groove plate piece can be easily replaced with a V-shaped groove plate made of a different material in accordance with the material of the projection on the other side.

## Claims

1. A thin plate supporting container (1) comprising a container body (2) for housing therein a plurality of thin plates (S), a lid unit (4) for closing the container body (2), and slotted plates (3) fixed on side walls (2C, 2D) facing each other in the container body (2) and supporting the thin plates (S) housed on the inside from both sides,
wherein an attaching/detaching mechanism (12) is fixed for detachably attaching any one of a top flange (5) for a carrying mechanism and a handle (6) held by the user or both to the container body (2),
the attaching/detaching mechanism (12) has a sliding and supporting means (27) for slidably supporting the container body (2) and the top flange (5) or handle (6) so that the two members are slidable on each other, and locking means (28) for locking the two members slidably supported by the sliding and supporting means (27) so as not to be deviated from each other,
the sliding and supporting means (27) include supporting portions (30) fixed on one of members and sliding portions (31) fixed on the other member and which are to be inserted into the supporting portions (30) from the front side to the inner side,
the locking means (28) has a locking projection (33) fixed on the one of members or the other member, and a locking pawl (34) fixed on the other or one of members,
the locking pawl (34) is constructed by a contact portion (36) which comes into contact with the locking projection (33) and a supporting bar portion (39) for supporting the contact portion (36), and
the supporting bar portion (39) is formed so as to extend to the other-side member and to the front side of the sliding and supporting means (27), wherein
two supporting portions (30) and two sliding portions (31) of the sliding and supporting means (27) are placed in parallel, and each of the interval between the supporting portions (30) and the interval between the sliding portions (31) is set to be small on the front side and to be large on the inner side.

2. The thin plate supporting container (1) according to claim 1, wherein the contact portion (36) of the locking pawl (34) is fixed on the side of the other-side member than the base end portion of the supporting bar portion (39).

3. The thin plate supporting container (1) according to claim 1, further comprising guide rails (29) for guiding two members supported by the sliding and supporting means (27) so as to slide and performing positioning in a direction orthogonal to the sliding direction.

## Patentansprüche

1. Tragebehälter (1) für dünne Platten, der einen Behälter-Körper (2) zum Aufnehmen einer Vielzahl dünner Platten (S), eine Deckeleinheit (4) zum Schließen des Behälter-Körpers (2) sowie mit Schlitzen versehene Platten (3) umfasst, die an Seitenwänden (2C, 2D) einander zugewandt in dem Behälter-Körper (2) befestigt sind und die in dem Inneren aufgenommenen dünnen Platten (S) von beiden Seiten tragen,
wobei ein Mechanismus (12) zum Anbringen/Abnehmen befestigt ist, um einen oberen Flansch (5) für einen Beförderungsmechanismus oder einen Griff (6), der von einem Benutzer gehalten wird, an dem Behälter-Körper (2) anzubringen,
der Mechanismus (12) zum Anbringen/Abnehmen hat eine Verschiebe-und-Halte-Einrichtung (27), mit der der Behälter-Körper (2) und der obere Flansch (5) oder Griff (6) verschiebbar so gehalten werden, dass die zwei Elemente aufeinander verschoben werden können, und eine Arretiereinrichtung (28) aufweist, mit der die zwei von der Verschiebe-und-Halte-Einrichtung (27) verschiebbar gehaltenen Elemente so arretiert werden, dass sie nicht zueinander versetzt werden,
die Verschiebe-und-Halte-Einrichtung (27) Halteabschnitte (30) hat, die an einem der Elemente befestigt sind, und Verschiebeabschnitte (31) enthält, die an dem anderen Element befestigt sind und die von der Vorderseite zur Innenseite in die Halteabschnitte (30) eingeführt werden,
die Arretiereinrichtung (28) einen Arretiervorsprung (33) hat, der an dem einen der Elemente oder dem anderen der Elemente befestigt ist, sowie eine Arretierklinke (34) aufweist, die an dem anderen oder dem einen der Elemente befestigt ist,
die Arretierklinke (34) durch einen Kontaktabschnitt (36), der mit dem Arretiervorsprung (33) in Kontakt kommt, und einen tragenden Stegabschnitt (39) gebildet wird, der den Kontaktabschnitt (36) trägt, und
der tragende Stegabschnitt (39) so ausgebildet ist, dass er sich zu dem Element der anderen Seite und zu der Vorderseite der Verschiebe-und-Halte-Einrichtung (27) erstreckt, wobei
zwei Halteabschnitte (30) und zwei Verschiebeabschnitte (31) der Verschiebe-und-Halte-Einrichtung (27) parallel angeordnet sind und der Zwischenraum zwischen den Halteabschnitten (30) sowie der Zwischenraum zwischen den Verschiebeabschnitten (31) jeweils so eingerichtet sind, dass sie an der Vorderseite klein sind und an der Innenseite groß sind.

2. Tragebehälter (1) für dünne Platten nach Anspruch 1, wobei der Kontaktabschnitt (36) der Arretierklinke (34) an der Seite des Elementes der anderen Seite des Basis-Endabschnitts des tragenden Stegabschnitts (39) befestigt ist.

3. Tragebehälter (1) für dünne Platten nach Anspruch 1, der des Weiteren Führungsschienen (29) umfasst, mit denen zwei von der Verschiebe-und-Halte-Einrichtung (27) gehaltene Elemente geführt werden, um sie zu verschieben und eine Positionierung in einer Richtung senkrecht zu der Verschieberichtung durchzuführen.

## Revendications

1. Conteneur supportant des plaques minces (1) comprenant un corps de conteneur (2) pour loger en son sein plusieurs plaques minces (S), une unité formant couvercle (4) pour fermer le corps de conteneur (2), et des plaques rainurées (3) fixées sur des parois latérales (2C, 2D) se faisant face dans le corps de conteneur (2) et supportant les plaques minces (S) logées sur l'intérieur des deux côtés,
dans lequel un mécanisme de fixation / détachement (12) est fixé pour attacher de façon amovible n'importe laquelle d'une bride supérieure (5) pour un mécanisme de transport et d'une poignée (6) maintenue par l'utilisateur ou les deux au corps de conteneur (2),
le mécanisme de fixation / détachement (12) possède un moyen de support et de coulissement (27) pour supporter de manière coulissante le corps de conteneur (2) et la bride supérieure (5) ou la poignée (6) de sorte que les deux éléments peuvent coulisser l'un sur l'autre, et un moyen de verrouillage (28) pour verrouiller les deux éléments supportés de manière coulissante par le moyen de support et de coulissement (27) afin de ne pas être écartés l'un de l'autre,
le moyen de support et de coulissement (27) comporte des parties de support (30) fixées sur un des éléments et des parties de coulissement (31) fixées sur l'autre élément et qui doivent être insérées dans les parties de support (30) du côté avant vers le côté intérieur,
le moyen de verrouillage (28) possède une partie en saillie de verrouillage (33) fixée sur l'un ou l'autre des éléments en particulier, et un cliquet de verrouillage (34) fixé sur l'autre des éléments,
le cliquet de verrouillage (34) est construit par une partie de contact (36) qui entre en contact avec la partie en saillie de verrouillage (33) et une partie de barre de support (39) pour supporter la partie de contact (36), et
la partie de barre de support (39) est formée de façon à s'étendre vers l'élément de l'autre côté et vers le côté avant du moyen de support et de coulissement (27), dans lequel
deux parties de support (30) et deux parties coulissantes (31) du moyen de support et de coulissement (27) sont placées en parallèle, et chacun de l'intervalle entre les parties de support (30) et de l'intervalle entre les parties coulissantes (31) est fixé pour être petit sur le côté avant et pour être grand sur le côté intérieur.

2. Conteneur supportant des plaques minces (1) selon 1a revendication 1, dans lequel la partie de contact (36) du cliquet de verrouillage (34) est fixée sur le côté de l'élément de côté autre que la partie d'extrémité de base de la partie de barre de support (39).

3. Conteneur supportant des plaques minces (1) selon la revendication 1, comprenant en outre des rails de guidage (29) pour guider deux éléments supportés par le moyen de support et de coulissement (27) de façon à coulisser et effectuer un positionnement dans une direction orthogonale à la direction de coulissement.
